# EUROPÄISCHE PATENTSCHRIFT

(11) **EP 1 113 988 B1**
(45) Veröffentlichungstag und Bekanntmachung des Hinweises auf die Patenterteilung: **24.04.2002**
(21) Anmeldenummer: 99938392.0
(22) Anmeldetag: 30.07.1999
(51) Int. Cl.: C01B 33/158, H01L 21/316

(54) **VERFAHREN UND ANLAGE ZUR HERSTELLUNG VON AEROGELEN**
METHOD AND DEVICE FOR PRODUCING AEROGELS
PROCEDE ET DISPOSITIF DE FABRICATION D'AEROGELS

(30) Priorität: 30.07.1998 DE 19834265
(43) Veröffentlichungstag der Anmeldung: 11.07.2001
(73) Patentinhaber: Gessner, Thomas, 09113 Chemnitz (DE); Schulz, Stefan E., 09111 Chemnitz (DE); Winkler, Thoralf, 13587 Berlin (DE)
(72) Erfinder: Gessner, Thomas, 09113 Chemnitz (DE); Schulz, Stefan E., 09111 Chemnitz (DE); Winkler, Thoralf, 13587 Berlin (DE)
(74) Vertreter: Schmidt, Frank-Michael, Dr.-Ing.
(86) Internationale Anmeldenummer: EP9905538
(87) Internationale Veröffentlichungsnummer: WO0006491

(56) Entgegenhaltungen:
- EP-A- 0 775 669
- WO-A-92/03378
- HRUBESH L W ET AL: "Thin aerogel films for optical, thermal, acoustic and electronic applications" JOURNAL OF NON-CRYSTALLINE SOLIDS,NL,NORTH-HOLLAND PHYSICS PUBLISHING. AMSTERDAM, Bd. 188, Nr. 1-2, Seite 46-53 XP004067975 ISSN: 0022-3093
- CHANGMING JIN ET AL: "Porous silica xerogel processing and integration for ULSI applications" LOW-DIELECTRIC CONSTANT MATERIALS IV. SYMPOSIUM, LOW-DIELECTRIC CONSTANT MATERIALS IV. SYMPOSIUM, SAN FRANCISCO, CA, USA, 14-16 APRIL 1998, Seiten 213-222, XP002125490 1998, Warrendale, PA, USA, Mater. Res. Soc, USA ISBN: 1-55899-417-3
- JO M ET AL: "Evaluation of SiO2 aerogel thin film with ultra low dielectric constant as an intermetal dielectric" MICROELECTRONIC ENGINEERING,NL,ELSEVIER PUBLISHERS BV., AMSTERDAM, Bd. 33, Nr. 1, Seite 343-348 XP004054530 ISSN: 0167-9317

## Beschreibung

Die Erfindung betrifft ein Verfahren und eine zugehörige Anlage zur Herstellung einer Aerogel-Schicht auf einem Substrat.

Aereogele sind hochporöse Materialien aus Silizium- oder Metalloxiden, die sich durch besonders niedrige Dichten von 70 - 300 kg/m³ bei extrem hohen inneren Oberflächen von bis zu 1000 m²/g auszeichen (vergl. DE 39 24 244 A1). Sie werden aus einem Lyogel hergestellt, welches in einem Sol-Gel-Prozeß aus einem Lyosol hergestellt wird. Gele sind formbeständige disperse Systeme aus wenigstens zwei Komponenten, zumeist aus einem festen, kolloidalverteilten Stoff mit langen oder stark verzweigten Teilchen und einem Dispersionsmittel. Ist das Dispersionsmittel zwischen den Teilchen eine Flüssigkeit, liegt ein Lyogel vor. Wird die Flüssigkeit des Lyogels durch Luft als Dispersionsmittel ersetzt, entsteht ein Aerogel.

Ein bekanntes Verfahren zur Herstellung eines SiO₂-Aerogels wird von S.S. Kistler in J.Phys.Chem., 36 (1932), Seiten 52 - 64, beschrieben. Dort wird als Vorläufersubstanz (Precursor) Wasserglas und Säure (HCl; H₂SO₄) eingesetzt. Dabei wird ein Hydrogel gebildet, bei dem anschließend das Wasser durch Ethanol oder Methanol substituiert wird. Das entstandene alkoholhaltige Gel wird anschließend im Autoklaven einem Druck von mehr als 71 bar und einer Temperatur > 100°C ausgesetzt. Das Lösungsmittel befindet sich in einem Zustand oberhalb des kritischen Punkts, bei dem es keine Oberflächenspannungen mehr gibt. Das Lösungsmittel kann aus dem Gel entweichen, ohne daß aufgrund der Oberflächenspannungen ein Schrumpfen des Gels stattfindet. Das entweichende Lösungmittel wird abgeführt, so daß es zur Trockung des Gels kommt. Es entsteht ein Aerogel. Nachteilig bei dieser sogenannten überkritischen Trockung im Autoklaven sind die hohen Drücke und Temperaturen, welche zu einem teuren Verfahren führen. Es sind darüber hinaus Verfahren bekannt, bei denen der Alkohol durch Kohlendioxid ersetzt wird, was eine überkritische Trockung bei geringeren Temperaturen gestattet.

In der Internationalen Patentveröffentlichung WO 92/20623 A1 sind darüber hinaus zwei weitere Verfahren erwähnt. Ein erstes dort erwähntes Verfahren ist die Gefriertrocknung. Dabei wird ein Alcogel (d.h. ein Lyogel mit Alkohol als Dispersionsmittel) gefroren, so daß ein festes Gel entsteht. Anschließend wird das Lösungsmittel unter reduziertem Druck durch Sublimation entfernt. Die Druckschrift nennt keine dazu geeigneten Lösungsmittel und verwirft darüber hinaus dieses Verfahren wegen einer nachteiligen Volumenausdehnung während der Kristallisation bzw. während des Einfrierens. Darüber hinaus beschäftigt sich die Druckschrift mit einem Verfahren zum direkten Verdampfen des Lösungsmittels aus der flüssigen Phase in die Gasphase. Durch eine geeignete Lösungsmittelmischung und Verfahrensführung sollen die Negativeinflüsse der Grenzflächenspannungen minimiert werden.

Auch aus der Druckschrift WO 95/17347 A1 ist ein Verfahren bekannt, das zur Vermeidung der Nachteile der überkritischen Trocknung eine unterkritische Verdampfung bei gegenüber dem Normaldruck erhöhtem oder abgesenktem Druck oder bei dem normalen Umgebungsdruck vorschlägt. Auch hier werden die nachteiligen Einflüsse der Oberflächenspannung der verdampfenden Flüssigkeit durch eine geeignete Verfahrensführung und/oder geeignete Lösungsmittel, die eine geringe Oberflächenspannung zeigen, gemindert. Obwohl die Druckschrift pauschal eine große Anzahl von möglichen Lösungsmitteln nennt, werden nur Ausführungsformen mit dem Lösungsmittel Isopropanol, gegebenenfalls unter Zusatz von Methanol, näher beschrieben.

Ein Verfahren zur Herstellung von Aerogelen, die auch in der Mikroelektronik Anwendung finden sollen, wird in EP O 775 669 A2 beschrieben. Es wird ein Precursor aus Tetraethoxysilan (TEOS), Wasser und Multisolvent (Lösungsmittelgemisch aus einem Polyol und Ethanol) eingesetzt. Nach der Abscheidung des Gels durch Auf schleudern auf einer Halbleiterscheibe wird das Ethanol verdampft. Nach Zugabe eines Katalysators aus der Gasphase erfolgt eine Vergelung, wobei ein nasses SiO₂-Netzwerk entsteht; anschließend wird das Gel durch Verdampfung des Polyols getrocknet. Durch eine Reaktion zwischen dem Polyol und TEOS ist die Lager- und Transportzeit des Precursors stark eingeschränkt. Die Zugabe des Katalysators aus der Gasphase führt zu einem vertikalen Diffusionsgradienten in der Aereogelschicht, wodurch es zu inhomogenen Schichteigenschaften in vertikaler Richtung kommen kann.

Aufgabe der Erfindung ist es, eine Aerogel-Schicht mit homogenen Eigenschaften auf einfache und kostengünstige Weise herzustellen.

Diese Aufgabe wird durch ein Verfahren mit den Merkmalen des Patentanspruchs 1 gelöst. Eine bevorzugte Anlage zur Durchführung des Verfahrens ist im Patentanspruch 24 angegeben.

Bei dem erfindungsgemäßen Verfahren zum Herstellen einer Aerogel-Schicht auf einem Substrat wird zunächst ein Precursor (eine Vorläufersubstanz) bereitgestellt, indem wenigstens ein Stoff aus einer Silicate, Metallalkoholate, Aluminate und Borate umfassenden Stoffgruppe mit einem Lösungsmittel zur Bildung eines Lyosolgemischs gemischt wird. Silicate umfassen die Salze und Ester der Orthokieselsäure und deren Kondensationsprodukte, also beispielsweise die Kieselsäuren und die Siliziumalkoholate (auch Siliziumalkoxyde oder Alkoxysilane genannt). Ein Lyosol ist eine kolloidale Lösung, bei der ein fester oder flüssiger Stoff in einem flüssigen Medium dispergiert ist. Zur Bildung des Lyosols kann gegebenenfalls die Zugabe von Wasser erforderlich sein. Das Lyosol entsteht nicht unmittelbar bei Mischung des Stoffes mit dem Lösungsmittel, sondern erst nach einer beginnenden chemischen Umsetzung (z.B. Hydrolyse und Polykondensation).

Anschließend wird die Precursor-Mischung oder das daraus gebildete Lyosol auf das Substrat aufgebracht. Aufgrund weiterer chemischer Umsetzung (Hydrolyse und Polykondensation) wird aus dem Lyosol ein Gel gebildet, wobei eine Temperatur gewählt wird, bei der das Lösungsmittel in einem flüssigen Zustand vorliegt. Der Druck ist vorzugsweise so gewählt, daß er zwischen 0,5 und 2 bar liegt, d.h. unter anderem den Normaldruck sowie einen geringen Unterdruck umfaßt. Der Druckbereich ist prozeßtechnisch relativ einfach einstellbar. Die Temperatur wird so gewählt, daß das Lösungsmittel in einem flüssigen Zustand vorliegt, um die Gel-Bildung zu fördern.

Nachdem das Gel gebildet worden ist (wobei geringfügige Anteile der Ausgangsstoffe und Produkte der Reaktionen in dem Gel verblieben sein können) wird bei einem Druck zwischen 0,5 und 2 bar die Temperatur um etwa 2 - 70 K, vorzugsweise 5 - 15 K, unter den Punkt abgesenkt, bei dem das Lösungsmittel in den festen Zustand übergeht (erstarrt). Die nur geringfügige Absenkung der Temperatur unter den Erstarrungspunkt dient einerseits der Einsparung von Energie und der Beschleunigung des Verfahrens, andererseits führt dies zu einer geringeren Belastung der Gel-Schicht durch temperatur- und erstarrungsinduzierte mechanische Spannungen. Anschließend wird in einer Trocknungskammer unter Absenkung des Drucks das Lösungsmittel unterhalb des Tripelpunktes in einen gasförmigen Zustand überführt und aus der Gel-Schicht entfernt. Dabei wird das gasförmige Lösungsmittel aus der Trocknungskammer abgeführt. Bei der Absenkung des Druckes kann die Temperatur konstant gehalten oder auch wiederum erhöht werden. Wesentlich ist lediglich, daß die Zustandsänderung vom festen in den gasförmigen Zustand ohne Durchlaufen des flüssigen Zustands, d.h. unterhalb des Tripelpunktes, geschieht.

Vorteilhafterweise wird ein Lösungsmittel verwendet, das einen Tripelpunkt bei einer Temperatur oberhalb 0°C, vorzugsweise oberhalb 15 °C, aufweist. Dies gestattet eine erhebliche apparative Vereinfachung, da zur Kühlung Kühlwasser verwendet werden kann.

Bei einer vorteilhaften Ausführungsform des erfindungsgemäßen Verfahrens wird als Lösungsmittel eine niedermolekularer tertiärer Alkohol verwendet. Einerseits weisen niedermolekulare tertiäre Alkohole, insbesondere t-Butanol, einen Tripelpunkt bei einer relativ hohen Temperatur auf. Andererseits sind tertiäre Alkohole weniger reaktionsfähig und neigen weniger zur Umesterung. Sie weisen somit eine bessere Verträglichkeit mit einem großen Teil der die Silicate umfassenden Stoffgruppe auf, was zu einer besseren Transport- und Lagerfähigkeit der Precursor-Mischung führt. Darüber hinaus gestatten ihre Verdunstungseigenschaften eine schnelle Sublimation.

Bei einer bevorzugten Ausführungsform des erfindungsgemäßen Verfahrens wird ein Precursor bereitgestellt, indem ein zum überwiegenden Teil aus einem Alkoxysilan bestehender Stoff mit einem niedermolekularen tertiären Alkohol als Lösungsmittel sowie mit Wasser gemischt wird. Aus einem solchen Precursor wird ein im wesentlichen aus Siliziumoxid bestehendes Aerogel gebildet. Neben dem überwiegenden Anteil des Alkoxysilans kann die Mischung beispielsweise einen geringen Anteil eines Metallalkoholats oder Borats umfassen, um die Siliziumoxid-Struktur zu modifizieren. Die Wasser-Beigabe dient der Hydrolyse des Alkoxysilans, wobei die entstehenden Produkte durch Polykondensation vernetzen. Obwohl bei letzterer wieder Wasser gebildet wird, wird bei der Hydrolyse eine größere Menge verbraucht. Vorzugsweise wird Tetraethoxysilan (TEOS) verwendet. Als niedermolekularer tertiärer Alkohol wird vorzugsweise t-Butanol verwendet. Tetraethoxysilan ist ein preiswerter, in der Halbleitertechnologie häufig verwendeter Ausgangsstoff, der darüber hinaus nicht so giftig wie z.B. Tetramethoxysilan (TMOS) ist. Es hat sich gezeigt, daß die Kombination von Tetraethoxysilan mit t-Butanol zu einem Precursor mit einer ausgezeichneten Haltbarkeit und hervorragenden Verarbeitungseigenschaften führt, zu denen unter anderem einer relativ geringe Gesundheitsgefährdung gehört. Die Stoffkombination weist darüber hinaus eine gute Mischbarkeit mit Wasser auf, welches als Reaktionspartner für die Hydrolyse des Tetraethoxysilans benötigt wird.

Das bei den bevorzugten Ausführungsformen dem Precursor zusätzlich zu dem Lösungsmittel zugemischte Wasser dient vorrangig als Reaktionspartner für die Hydrolyse als einer Voraussetzung des Sol-Gel-Verfahrens. Vorzugsweise wird der Precursor bereitgestellt, indem zunächst ein Stoff der eingangs genannten Stoffgruppe mit dem Lösungsmittel vermischt wird, wobei das (bei Raumtemperatur möglicherweise feste) Lösungsmittel vor dem Mischen durch Erwärmen verflüssigt wird. Anschließend wird das Wasser zugemischt. Vorzugsweise wird zur Beschleunigung der Gel-Bildung ein Katalysator zugegeben. Dabei sind sowohl mehrstufige Katalyse-Verfahren, bei denen zunächst ein erster Katalysator (z.B. NH₄OH) die Hydrolyse und anschließend ein zweiter Katalysator (z.B. HCl) die Polykondensation fördert, als auch die Zugabe nur eines Katalysators (z.B. HF), der beide Reaktionen beschleunigt, denkbar. Die Verwendung eines Katalysators, der vorzugsweise in einer wäßrigen Lösung zugegeben wird, beschleunigt das Verfahren und erhöht somit dessen Wirtschaftlichkeit.

Eine bevorzugte Ausführungsform des erfindungsgemäßen Verfahrens ist dadurch gekennzeichnet, daß vor dem Aufbringen des Lyosols auf das Substrat ein Vor-Vergelen stattfindet. Dies erhöht die Viskosität der Substanz, so daß mit einfachen, üblichen Aufbringungsverfahren, beispielsweise durch Auf schleudern, relativ dicke Schichten des Gels hergestellt werden können.

Bei einer bevorzugten Ausführungsform des erfindungsgemäßen Verfahrens wird die auf dem Substrat ausgebildete Gel-Schicht vor dem Absenken der Temperatur zum Erstarren des Lösungsmittels mit dem Lösungsmittel gespült. Dies dient der Anreicherung des Lösungsmittels in der Gel-Schicht und dem gleichzeitigen Entfernen überschüssiger Ausgangsstoffe der Hydrolyse- und Kondensationsreaktionen. Vorteilhafterweise kann gleichzeitig ein hydrophobisierendes Mittel der Spülung zugegeben werden, welches OH-Gruppen und Wasser in der Gel-Schicht durch Alkyl-Gruppen austauscht (z.B. Hexamethyldisilazan oder Trimethylchlorsilan).

Eine bevorzugte Ausführungsform des erfindungsgemäßen Verfahrens ist dadurch gekennzeichnet, daß ein Precursor bereitgestellt wird, indem Tetraethoxysilan mit mehr als der 2-fachen Stoffmenge (Mol) t-Butanol, vorzugsweise mit der 4-bis 30-fachen Stoffmenge t-Butanol bei einer Temperatur gemischt wird, bei der die Mischung in flüssiger Form vorliegt, und dabei Wasser in einer Stoffmenge zugegeben wird, die dem 4- bis 30-fachen, vorzugsweise etwa dem 6- bis 10-fachen der Stoffmenge des Tetraethoxysilans entspricht. Anschließend wird ein eine Hydrolyse und/oder Kondensation beschleunigender Katalysator zugegeben. Dann wird die Mischung vor dem Aufbringen auf das Substrat bei einer Temperatur gelagert, bei der die Mischung flüssig bleibt, sowie unter einer mit t-Butanol gesättigten Atmosphäre. Dabei findet ein Vor-Vergelen statt, welches die Viskosität erhöht. Je nach Wahl des Katalysators wird die Mischung vorzugsweise für eine Dauer zwischen einer Stunde und mehreren Tagen gelagert. Es sind auch Katalysatoren denkbar, die eine kürzere Zeit gestatten. Anschließend wird die vor-vergelte Mischung durch Aufschleudern auf das Substrat aufgebracht und durch Absenken der Temperatur zum Erstarren gebracht. Diese Schritte finden vorzugsweise bei Drücken zwischen 0,5 und 1 bar statt. Schließlich wird in einer Trocknungskammer unter Absenkung des Druckes unter 0,05 bar das t-Butanol unterhalb des Tripelpunkts in einen gasförmigen Zustand überführt und dabei aus der Gel-Schicht entfernt. Das gasförmige t-Butanol wird aus der Trocknungskammer abgeführt. Nach dem Trocknen wird die auf dem Substrat aufgebrachte Aerogel-Schicht bei einer Temperatur zwischen 200 °C und 800 °C bei einer inerten Gasatmosphäre oder einer Unterdruck-Luftatmosphäre nachbehandelt. Dabei werden sowohl die Reste des Wassers als auch Reste unerwünschter überschüssiger Ausgangsstoffe entfernt. Vorzugsweise wird anschließend eine Behandlung mit einem hydrophobisierenden Mittel (z.B. Hexamethyldisilazan oder Trimethylchlorsilan) durchgeführt, um verbliebene OH-Gruppen (oder Wasser) gegen Methyl- oder andere Alkylgruppen auszutauschen. Diese Behandlung kann in der Gasphase ausgeführt werden.

Die Anlage zur Durchführung des Verfahrens weist ein erstes Modul auf, in dem die Schritte des Aufbringens der Sol-Gel-Schicht auf das Substrat, der Gel-Bildung und der Gel-Erstarrung durchgeführt werden. Dieses Modul weist wenigstens eine Kammer mit einer Einrichtung zum Herstellen einer gesättigten Atmosphäre des Lösungsmittels und mit einer Einrichtung zum Einstellen der Temperatur auf. Eine Einrichtung zum Einstellen eines Druckes in der Kammer ist in der Regel nicht erforderlich, sofern die genannten Schritte bei Normaldruck durchgeführt werden.

Die Anlage weist darüber hinaus ein zweites Modul auf, das eine gasdicht verschließbare Trocknungskammer umfaßt. Die Trocknungskammer ist mit einer Einrichtung zum Absenken des Druckes in der Kammer und einer Einrichtung zum Abführen des in den gasförmigen Zustand überführten Lösungsmittels aus der Trocknungskammer versehen. Vorzugsweise ist zwischen dem ersten und zweiten Modul eine Transportvorrichtung für das Substrat eingekoppelt. Diese ist darüber hinaus mit einem dritten Modul zur Nachbehandlung gekoppelt, wobei das dritte Modul eine Kammer mit einer Tempereinrichtung zum Erhöhen der Substrattemperatur auf eine Temperatur zwischen 200 °C und 800 °C und einer Einrichtung zur Schaffung einer Unterdruck- oder Inertgasatmosphäre in der Kammer aufweist.

Andere vorteilhafte Weiterbildungen der Erfindung sind in den Unteransprüchen gekennzeichnet.

Die Erfindung wird nachfolgend anhand von Ausführungsbeispielen und zugehörigen Zeichnungen näher erläutert. Es zeigen:
Figur 1 eine Blockdarstellung einer Anlage zum Herstellen der Aerogel-Schicht;
Figur 2 eine Prinzipdarstellung eines Abscheide- und Vergelungsmoduls;
Figur 3 ein Diagramm, das die Aerogel-Schichtdickenverteilung auf einer Siliziumscheibe veranschaulicht;
Figur 4 ein Zustandsdiagramm des verwendeten Lösungsmittels; und
Figur 5 ein Diagramm, das die Verbesserung der Schaltzeit bei Einsatz einer Aerogel-Schicht als Dielektrikum im Vergleich zu einer SiO₂-Schicht zeigt.

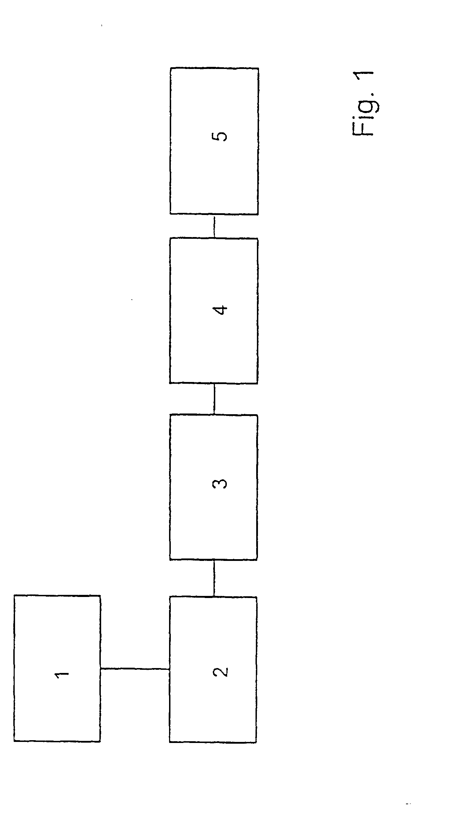

Figur 1 zeigt eine Bockdarstellung einer Anlage zum Herstellen einer Aerogel-Schicht auf einem Substrat. Die Anlage besteht aus einem Mischmodul 1, einem Abscheidemodul 2, einem Vergelungsmodul 3, einem Trocknungsmodul 4 und einem Nachbehandlungsmodul 5. Im folgenden wird ein bevorzugtes Verfahren zum Herstellen der Aerogel-Schicht beschrieben, bei dem die einzelnen Verfahrensschritte nacheinander in den verschiedenen Modulen gemäß Figur 1 ausgeführt werden. Bei alternativen Ausführungsformen können auch mehrere Module zusammengefaßt werden, d.h. mehrere Verfahrensschritte an einem Ort bzw. in einem Modul ausgeführt werden.

Zunächst wird in dem Mischmodul ein Precursor bereitgestellt. Vorzugsweise werden zunächst die drei Komponenten Tetraethoxysilan, t-Butanol (tertiäres Butanol) und Wasser gemischt. Eine vorgegebene Menge des bei Raumtemperatur in fester Form vorliegenden t-Butanols wird abgemessen und zur Verflüssigung erwärmt. Das erwärmte flüssige t-Butanol wird anschließend mit einer vorgegebenen Menge TEOS gemischt. Gleichzeitig oder anschließend wird eine vorgegebene Menge Wasser zugemischt. Dabei kann zu einem Stoffmengenanteil TEOS etwa die 4- bis 30-fache Stoffmenge (in Mol) t-Butanol und die 4- bis 30-fache Stoffmenge Wasser hinzugemischt werden. Zur Beschleunigung der Hydrolyse- und Kondensationsprozesse wird anschließend ein Katalysator zugegeben. Da der Katalysator in wäßriger Lösung zugegeben wird, ist die dabei zugegebene Wassermenge bei der Festlegung der zuvor zuzugebenen Wassermenge zu berücksichtigen. Gegenwärtig werden zwei Arten von Katalysatoren bevorzugt. Ein Verfahren stellt eine zweistufige Katalyse dar, bei der zunächst eine Ammoniumhydroxidlösung zur Einstellung eines pH-Wertes > 10 der Mischung zugegeben wird, wodurch die Hydrolyse beschleunigt wird. Nach einer gewissen Hydrolyse-Reaktionszeit wird durch Zugabe eines zweiten Katalysators in Form einer Säure (HCl) ein pH-Wert < 2 eingestellt, wodurch die Polykondensation beschleunigt wird und bevorzugt abläuft. Bei einem alternativen Verfahren wird nach der Mischung des TEOS mit dem t-Butanol und dem Wasser nur ein Katalysator zugegeben, beispielsweise in Form einer 40%-igen Flußsäure (HF) zur Beschleunigung von Hydrolyse und Polykondensation. Auch die Zugabe von HNO₃ ist denkbar.

Bei der zweistufigen Katalyse werden folgende Mengen bevorzugt: 1 Mol-Anteil TEOS wird mit 10 Anteilen t-Butanol und 8 Anteilen Wasser gemischt. Dieser Mischung werden zunächst 10 Vol.-% 0,1 N NH₄OH-Lösung zugegeben. In der zweiten Stufe werden 0,5 Vol.-% HCl-Lösung zugegeben. Nach deren Zugabe beträgt das Verhältnis TEOS : Wasser : t-Butanol = 1 : 15, 3 : 10. Für 100 ml Sol werden beispielsweise 15,9 g TEOS mit 56,5 g t-Butanol und 11 g Wasser vermischt; anschließend werden 10 Vol.-% (10 ml) des ersten Katalysators (0,5 N NH₄OH) und dann 0,5 Vol.-% (0,5 ml) des zweiten Katalysators (HCl, 32%-ig) zugegeben. Ein solcher zweistufiger Ansatz läßt sich auch herstellen, indem 21,37 g t-Butanol mit 21,37 ml TEOS gemischt werden und dieser Mischung 10,37 ml Wasser zugegeben wird. Anschließend können 0,6 ml NH₄OH und 1,7 ml HCl zugegeben werden.

Nach der Zugabe des zweiten Katalysators findet ein Vor-Vergelen (z.B. bei ca. 30 °C über fünf Tage) statt. Anschließend wird die bei dem Vor-Vergelen gebildete Sol-Gel-Substanz mittels Aufschleudern im Abscheidemodul 2 (Figur 1) auf ein Substrat (beispielsweise eine Siliziumscheibe) abgeschieden. Die so beschichteten Substrate gelangen anschließend in das Vergelungsmodul 3, wo sie sich, beispielsweise bei Temperaturen um 30 °C, zur Vergelung und Alterung über weitere fünf Tage aufhalten. Anschließend gelangen die Substrate mit der gebildeten Gel-Schicht in das Trocknungsmodul 4, welches eine Druckkammer umfaßt. Zunächst wird dort die Temperatur der Gel-Schicht auf eine Temperatur abgesenkt, die unterhalb des Erstarrungspunktes liegt. Der Druck kann dabei bei Normaldruck gehalten oder auch geringfügig abgesenkt werden. Nach dem Erstarren der Gel-Schicht wird der Druck in der Trocknungskammer auf unter 0,05 bar abgesenkt, wobei eine Zustandsänderung des Lösungsmittels (t-Butanols) unterhalb des Tripelpunktes vom festen in den gasförmigen Zustand durchgeführt wird. Das gasförmige t-Butanol entweicht aus der Gel-Schicht und wird aus der Trocknungskammer abgeführt. Diese Trocknung dauert beispielsweise eine Stunde.

Anschließend werden die Substrate mit dem gebildeten Aerogel in ein Nachbehandlungsmodul 5 überführt, wo sie bei einer Temperatur zwischen 200 °C und 800 °C bei Unterdruck oder in einer inerten Gasatmosphäre (z.B. Stickstoff) getempert werden, beispielsweise für 30 Minuten bis 3 Stunden.

Mit diesem zweistufigen Katalyse-Verfahren und den angegebenen technologischen Parametern wurden beispielsweise folgende Schichteigenschaften auf einem Siliziumwafer erzielt:
- relative Dielektrizitätskonstante εᵣ < 1,7
- innere Fläche Aᵢ 500 m²/g
- Oberflächenrauhigkeit - Rauhtiefe Rₐ < 8nm über eine Fläche von (200µm)²
- Brechungsindex ca. 1,12 bis 1,15.
Zwei alternative Ausführungsformen des erfindungsgemäßen Verfahrens verwenden eine einstufige Katalyse, d.h. eine einmalige Zugabe eines Katalysators. Hierfür sollen zwei Beispielmischungen angegeben werden:

### Beispiel 1: Sol S

100 ml Sol TEOS : Wasser : t-Butanol
22,8g : 14,8g : 47,9g
+ 0,2 Vol.-% (= 0,2 ml) Katalysator (HF, 40%ig) entspricht den molaren Verhältnissen von:
TEOS : Wasser : t-Butanol
vor Zugabe des wasserhaltigen Katalysators:
1 : 7,45 : 5,87
nach Zugabe des wasserhaltigen Katalysators:
1 : 7,55 : 5,87

### Beispiel 2: Sol B

100 ml Sol TEOS : Wasser : t-Butanol
13,1g : 8,1g : 61,4g
+ 1 Vol.-% (= 1 ml) Katalysator (HF, 40 %ig) molare Mengenverhältnisse:
TEOS : Wasser : t-Butanol
vor Zugabe des wasserhaltigen Katalysators:
1 : 7 : 13
nach Zugabe des wasserhaltigen Katalysators:
1 : 5,5 : 13.

Bei den Verfahren mit einstufiger Katalyse konnten die Prozeßzeiten weiter verringert werden. Nach dem Mischen und der Zugabe des Katalysators findet ein Vor-Vergelen des Sols bei einer Temperatur von beispielsweise 32 °C über etwa 90 Minuten statt. Anschließend wird die Schicht mittels Aufschleudern auf dem Substrat abgeschieden. Die Vergelung und Alterung dauert bei einer Temperatur von ca. 32 °C etwa 90 Minuten. Anschließend wird auf eine Temperatur von etwa 15 °C abgekühlt. Nach dem Erstarren der Gel-Schicht erfolgt die Trocknung durch Sublimieren des t-Butanols bei etwa 15 °C und einem Druck von ≤ 0,05 bar, was eine Zeit von etwa einer halben bis einer Stunde beansprucht. Anschließend wird die Gel-Schicht bei einer Temperatur von 200°C bis 800 °C im Unterdruck oder bei einer inerten Gasatmosphäre nachbehandelt. Mit diesen technologischen Parametern wurden beispielsweise folgende Eigenschaften einer auf einer Siliziumscheibe aufgebrachten Schicht erzielt:
- Porosität - 66 % Luft und 34 % Feststoff
- chemische Zusammensetzung Si:O:H = 1:2:0.28
- Porengröße < 10 nm
- erzielbare Schichtdicken 200 - 600 nm
- Brechungsindex < 1,2.

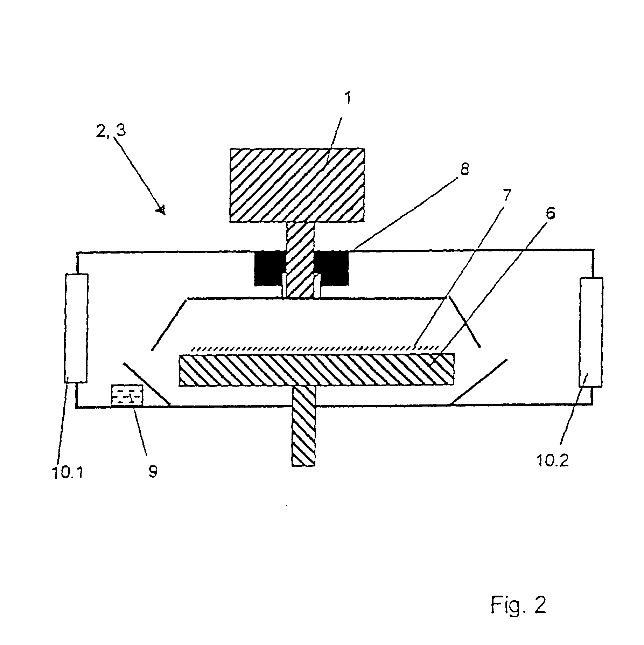

Neben der in Figur 1 gezeigten getrennten Ausführung der Module ist es auch möglich, mehrere Module zusammenzufassen, d.h., mehrere Verfahrensschritte in einer Prozeßkammer durchzuführen. Figur 2 zeigt eine Anordnung, in der Mischmodul 1, Abscheidemodul 2 und Vergelungsmodul 3 zusammengefaßt sind. Das Mischmodul 1 befindet sich oberhalb einer Prozeßkammer. In der Prozeßkammer befindet sich ein Auflagetisch (Waferchuck) 6, auf den ein Substrat 7 (Wafer; Siliziumscheibe) aufgelegt ist. Über die Dosiervorrichtung 8 wird eine vorgegebene Menge der Sol-Gel-Mischung auf das Substrat 7 aufgebracht. Anschließend wird eine gleichmäßige Schicht durch Aufschleudern, d.h. durch Rotation des Auflagetisches 6, auf dem Substrat erzeugt. In der Prozeßkammer befindet sich eine Einrichtung 9 zum Verdampfen des Lösungsmittels (t-Butanol). In der Wandung der Prozeßkammer sind Schleusen 10.1 und 10.2 zur Beschickung und Entnahme des Substrates vorgesehen.

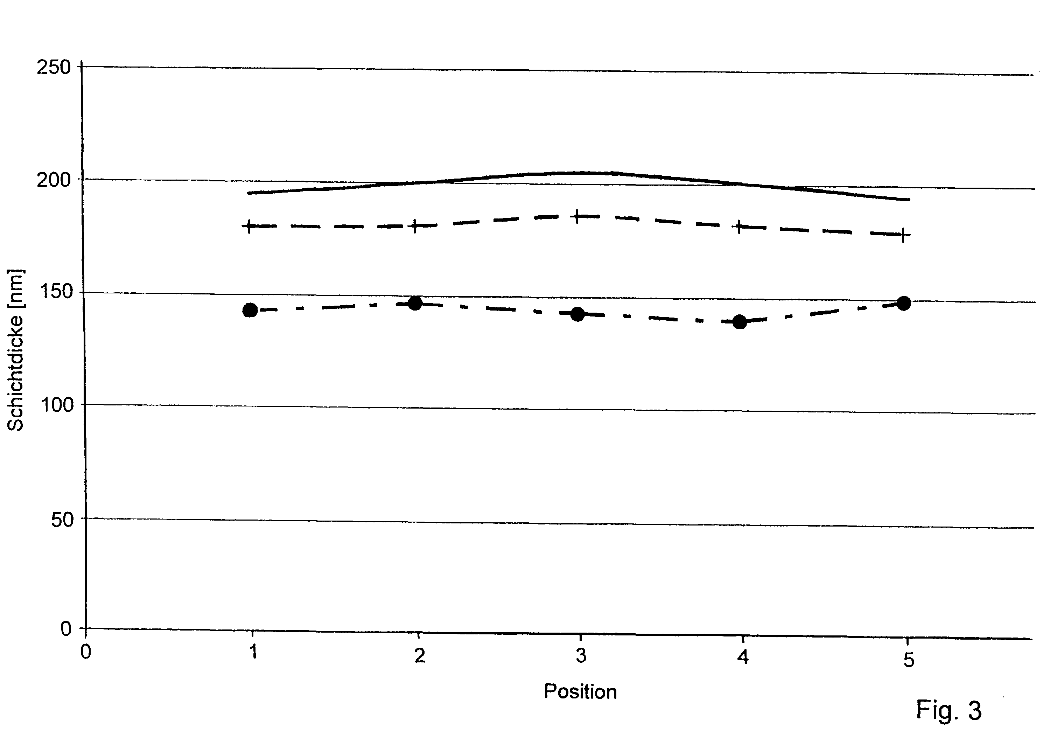

Das Diagramm gemäß Figur 3 veranschaulicht die an drei beispielhaften Aerogel-Schichten auf 100mm-Siliziumscheiben an jeweils 5 Positionen gemessenen Schichtdicken. Bei den dargestellten Proben wurde TEOS und t-Butanol zur Herstellung des Precursors verwendet. Aus dem Diagramm ist ersichtlich, daß mit dem genannten Verfahren eine sehr gleichmäßige Schichtdicke der Aerogel-Schicht zu erzielen ist. Dies gestattet die Anwendung des Verfahrens in einem Prozeß zur Herstellung integrierter Schaltungs-Chips, die in einer Vielzahl auf einem Substrat ausgebildet werden. Die gleichmäßige Schichtdicke führt zu geringen Schwankungen zwischen den auf dem Substrat verteilten Chips. Wesentlicher ist allerdings die noch geringere Schwankung innerhalb der Chips, damit die auf einem Chip hergestellten Bauelemente gleiche Parameter aufweisen.

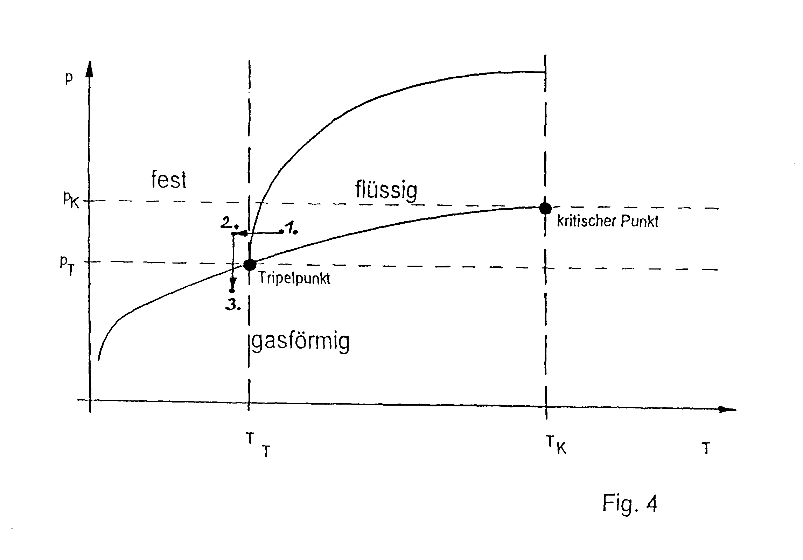

Figur 4 zeigt ein Druck-Temperatur-Zustandsdiagramm des verwendeten Lösungsmittels, beispielsweise von t-Butanol. Bei t-Butanol liegt der Tripelpunkt bei einem Druck von pₜ = 0,053 bar und einer Temperatur ϑₜ = 24,96 °C. Beim Mischen und Vergelen wird ein flüssiger Zustand eingestellt: Die Temperatur liegt oberhalb der Tripelpunkt-Temperatur, der Druck beispielsweise bei 1 bar. Nach der vollständigen Vergelung wird die Temperatur bei dem jeweilig vorliegenden Druck soweit verringert, daß sie etwa 3 - 70 K, vorzugsweise 5 - 15 K unter dem Erstarrungspunkt liegt. Beispielsweise wird die Temperatur auf etwa 10 bis 20 °C verringert. Nach dem Erstarren des t-Butanols wird der Druck abgesenkt, wobei ein Punkt angefahren wird, der in dem gasförmigen Bereich des Zustandsdiagramms gemäß Figur 4 liegt. Die von dem zuvor angefahrenen, im festen Bereich liegenden Punkt zu dem Punkt im gasförmigen Bereich verlaufende Gerade schneidet die Erstarrunggrenze unterhalb des Tripelpunktes, so daß das Lösungsmittel sublimiert. Je nach dem Ausgangspunkt im festen Bereich kann bei Absenken des Druckes die Temperatur auch geringfügig erhöht werden.

Mit dem erfindungsgemäßen Verfahren ist es möglich, auf Substraten homogene Aerogel-Schichten aufzubringen. Dabei eignen sich die durch Anwendung von Alkoxysilanen, insbesondere von TEOS, hergestellten Siliziumdioxid-Aerogelschichten als dielektrische Schichten mit einer sehr niedrigen relativen Dielektrizitätskonstante (εᵣ<2). Die Dielektrizitätskonstante der Schicht kommt somit der von Luft sehr nahe. Die Verringerung der Dielektrizitätskonstante kann für eine Verringerung parasitärer Kapazitäten von auf bzw. unter den Aerogel-Schichten verlaufenden metallischen Leitern genutzt werden. Die verringerten parasitären Kapazitäten führen bei hochfrequenten Anwendungen zu verringerten Signallaufzeiten und darüber hinaus zu einer Verringerung des Signal-Übersprechens dicht benachbarter Leitbahnen. Die so hergestellten Aerogel-Schichten sind bis 700 °C temperaturbeständig.

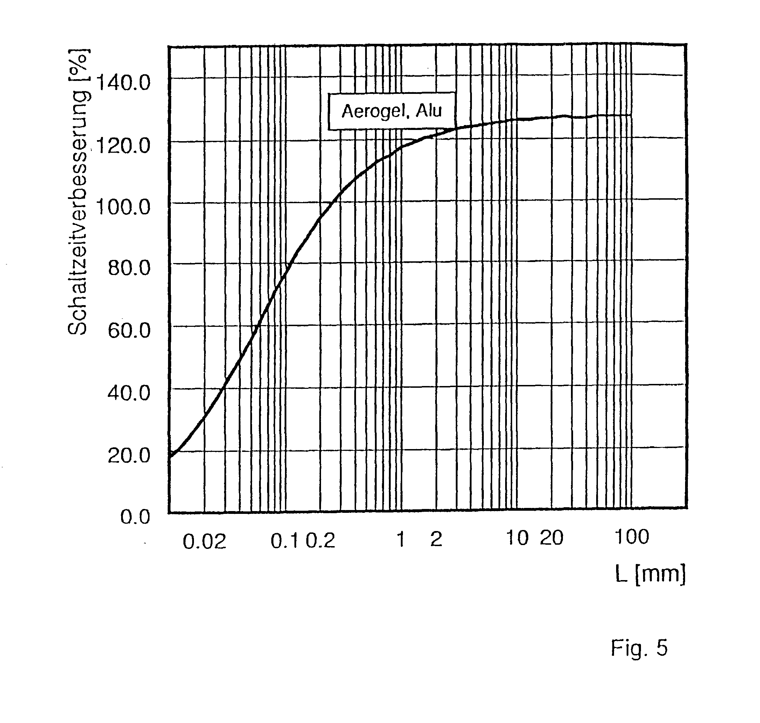

Figur 5 zeigt ein Diagramm, das die prozentuale Schaltzeitverbesserung bei Einsatz von Siliziumoxid-Aerogel-Schichten als Dielektrikum zwischen Aluminiummetallisierungen integrierter Schaltkreise im Vergleich zu herkömmlichen Siliziumdioxid-Schichten darstellt. Die relative Dielektrizitätskonstante des Aerogels wurde mit 1,7, die des Siliziumdioxids mit 3,9 angesetzt. Der spezifische Widerstand des Aluminiums wurde mit 3,7 µΩcm angesetzt. Weitere Parameter waren:
- Designwerte 0,18 µm (CMOS-Technologie),
- Treiberwiderstand 50 Ω, und
- Lastkapazität 5fF.

Aufgrund der genannten Eigenschaften der Aerogele können diese über die genannten Anwendungen hinaus auch bei folgenden Anwendungsgebieten eingesetzt werden, bei denen Stoffe mit großen inneren Oberflächen von Vorteil sind:
- Gassensoren
- Speicherung von Katalysatoren (z.B. für Mikroreaktoren),
- Wärmeisolationen,
- Hintergrundbeleuchtung für LCD-Bildschirme und
- Beschichtung größer Flächen für die Herstellung von Wärmeschutzgläsern.

## Patentansprüche

1. Verfahren zum Herstellen einer Aerogel-Schicht auf einem Substrat, wobei:
a) ein Precursor bereitgestellt wird, indem wenigstens ein Stoff aus einer Silikate, Metallalkoholate, Aluminate und Borate umfassenden Stoffgruppe mit einem Lösungsmittel zur Bildung eines Lyosols gemischt wird,
b) die Precursor-Mischung bzw. das daraus gebildete Lyosol auf das Substrat aufgebracht wird,
c) aus dem Lyosol ein Gel gebildet wird, wobei eine Temperatur gewählt wird, bei der das Lösungsmittel in einem flüssigen Zustand vorliegt,
d) anschließend bei einem Druck zwischen 0,5 und 2 bar die Temperatur um etwa 3 - 70 K, vorzugsweise 5 - 15 K, unter den Punkt abgesenkt wird, bei dem das Lösungsmittel in den festen Zustand übergeht, und
e) anschließend in einer Trocknungskammer unter Absenkung des Druckes das Lösungsmittel unterhalb des Tripelpunktes in einen gasförmigen Zustand überführt und aus der Gel-Schicht entfernt und das gasförmige Lösungsmittel aus der Trocknungskammer abgeführt wird.

2. Verfahren nach Anspruch 1, **dadurch gekennzeichnet, daß** ein Lösungsmittel verwendet wird, das einen Tripelpunkt bei einer Temperatur oberhalb 0°C, vorzugsweise oberhalb 15°C, aufweist.

3. Verfahren nach Anspruch 1, **dadurch gekennzeichnet, daß** als Lösungsmittel ein niedermolekularer tertiärer Alkohol, vorzugsweise t-Butanol verwendet wird.

4. Verfahren nach einem der Ansprüche 1 - 3, **dadurch gekennzeichnet, daß** im Schritt a) ein Precursor bereitgestellt wird, indem ein zum überwiegenden Teil aus einem Alkoxysilan bestehender Stoff mit einem niedermolekularen tertiären Alkohol als Lösungmittel sowie mit Wasser gemischt wird.

5. Verfahren nach Anspruch 4, **dadurch gekennzeichnet, daß** Tetraethoxysilan (TEOS) mit mehr als der 2-fachen Stoffmenge (Mol) t-Butanol, vorzugsweise mit der 4- bis 30-fachen Stoffmenge t-Butanol, gemischt und Wasser in einer Stoffmenge, die dem 2-fachen bis 30-fachen, vorzugsweise dem 6-bis 10-fachen, der Stoffmenge des Tetraethoxysilans entspricht, zugegeben wird.

6. Verfahren nach einem der Ansprüche 1 - 5, **dadurch gekennzeichnet, daß** im Schritt a) der Precursor bereitgestellt wird, indem zunächst ein Stoff der Stoffgruppe mit dem Lösungsmittel vermischt und anschließend das Wasser zugemischt wird, wobei das Lösungsmittel vor dem Mischen durch Erwärmen verflüssigt wird.

7. Verfahren nach einem der Ansprüche 1 - 6, **dadurch gekennzeichnet, daß** im Schritt a) zur Beschleunigung der Gel-Bildung ein Katalysator zugegeben wird.

8. Verfahren nach einem der Ansprüche 1 - 7, **dadurch gekennzeichnet, daß** vor dem Aufbringen des Lyosols auf das Substrat ein Vor-Vergelen stattfindet.

9. Verfahren nach Anspruch 8, **dadurch gekennzeichnet, daß** die Precursor-Mischung im Schritt a) für eine Dauer zwischen einer Stunde und mehreren Tagen bei einer Temperatur, bei der die Precursor-Mischung in flüssiger Form vorliegt, und unter einer mit dem Lösungsmittel gesättigten Atmosphäre gelagert wird.

10. Verfahren nach einem der Ansprüche 1 - 9, **dadurch gekennzeichnet, daß** nach dem Schritt c) und vor dem Schritt d) die auf dem Substrat aufgebrachte Gel-Schicht mit dem Lösungsmittel gespült wird.

11. Verfahren nach Anspruch 10, **dadurch gekennzeichnet, daß** bei dem Spülen ein hydrophobisierendes Mittel zugegeben wird, welches Wasser und OH-Gruppen in der Gel-Schicht durch Alkyl-Gruppen ersetzt.

12. Verfahren nach einem der Ansprüche 1 - 11, **dadurch gekennzeichnet, daß** die Schritte a) bis d) bei Drücken zwischen 0,5 und 1 bar durchgeführt werden.

13. Verfahren nach einem der Ansprüche 1 bis 12, **dadurch gekennzeichnet, daß** nach dem Entfernen des Lösungsmittels aus der Gel-Schicht im Schritt e):
f) die auf dem Substrat aufgebrachte Aerogel-Schicht bei einer Temperatur zwischen 200 °C und 800 °C bei einer inerten Gasatmosphäre oder einem Unterdruck getempert wird.

14. Verfahren nach Anspruch 13, **dadurch gekennzeichnet, daß** nach dem Tempern im Schritt f):
g) die Gel-Schicht mit einem hydrophobisierenden Mittel behandelt wird, das OH-Gruppen durch Alkylgruppen austauscht.

15. Anlage zur Durchführung eines Verfahrens nach einem der Ansprüche 1 bis 14,
**dadurch gekennzeichnet,**
**daß** die Schritte b) bis d) in einem ersten Modul durchgeführt werden, welches wenigstens eine Kammer mit einer Einrichtung zum Herstellen einer gesättigten Atmosphäre des Lösungsmittels und mit einer Einrichtung zum Einstellen der Temperatur aufweist, und
**daß** der Schritt e) in einem zweiten Modul durchgeführt wird, das eine gasdicht verschließbare Trocknungskammer mit einer Einrichtung zum Absenken des Druckes in der Kammer und eine Einrichtung zum Abführen des in den gasförmigen Zustand überführten Lösungsmittels aus der Trocknungskammer aufweist.

16. Anlage nach Anspruch 15, **dadurch gekennzeichnet, daß** der Schritt b) in einer Aufschleuder-Kammer und die Schritte c) und d) in einer Gelbildungskammer durchgeführt werden, wobei die Gelbildungskammer mehrere Substrate aufnehmen kann.

17. Anlage nach Anspruch 15 oder 16, **dadurch gekennzeichnet, daß** das erste und zweite Modul mit einer Transportvorrichtung für das Substrat gekoppelt sind und daß die Transportvorrichtung darüber hinaus das zweite Modul mit einem dritten Modul zur Nachbehandlung koppelt, wobei das dritte Modul eine Kammer mit einer Tempereinrichtung zum Erhöhen der Substrattemperatur auf eine Temperatur zwischen 200 °C und 800 °C und einer Einrichtung zur Schaffung einer Unterdruck- oder Inertgasatmosphäre in der Kammer aufweist.

## Claims

1. Method of producing an aerogel layer on a substrate, wherein:
a) a precursor is provided by mixing at least one material from a group including silicates, metal alcoholates, aluminates and borates with a solvent to form a lyosol;
b) the precursor mixture or the lyosol formed therefrom is applied to the substrate;
c) a gel is formed from the lyosol, a temperature being selected at which the solvent is present in a liquid state;
d) at a pressure of between 0.5 and 2 bar, the temperature is then reduced by about 3-70K, preferably 5-15K, below the point at which the solvent is converted into the solid state; and
e) the solvent is then converted into the gaseous state below the triple point in a drying chamber whilst reducing the pressure and is removed from the gel layer and the gaseous solvent is conducted out of the drying chamber.

2. Method claimed in claim 1, **characterised in that** a solvent is used which has a triple point at a temperature above 0°C, preferably above 15°C.

3. Method as claimed in claim 1, **characterised in that** a low-molecular tertiary alcohol, preferably t-butanol, is used as the solvent.

4. Method as claimed in one of claims 1 to 3, **characterised in that** a precursor is provided in step a) by mixing a material, predominantly comprising an alcoxysilane, with a low-molecular tertiary alcohol as a solvent and with water.

5. Method as claimed in claim 4, **characterised in that** tetraethoxysilane (TEOS) is mixed with more than twice the amount (moles), preferably with 4 to 30 times the amount of t-butanol and water is added in an amount which corresponds to twice to 30 times, preferably 6 to 10 times, the amount of the tetraethoxysilane.

6. Method as claimed in one of claims 1 to 5, **characterised in that** the precursor is provided in step a) by initially mixing a material from the group with the solvent and then adding the water, whereby the solvent is liquefied by heating before the mixing.

7. Method as claimed in one of claims 1 to 6, **characterised in that** a catalyst is added in step a) to accelerate the gel formation.

8. Method as claimed in one of claims 1 to 7, **characterised in that** pre-gelling takes place before the application of the lyosol to the substrate.

9. Method as claimed in claim 8, **characterised in that** in step a), the precursor mixture is stored for a period of between one hour and several days at a temperature at which the precursor mixture remains liquid and under an atmosphere saturated with the solvent.

10. Method as claimed in one of claims 1 to 9, **characterised in that** the gel layer applied to the substrate is rinsed with the solvent after step c) and before step d).

11. Method as claimed in claim 10, **characterised in that** in the rinsing step, a hydrophobing agent is added which replaces water and OH groups in the gel layer by alkyl groups.

12. Method as claimed in one of claims 1 to 11, **characterised in that** the steps a) to d) occur at pressures between 0.5 and 1 bar.

13. Method as claimed in one of claims 1 to 12, **characterised in that** after the removal of the solvent from the gel layer in step e)
f) the aerogel layer applied to the substrate is tempered at a temperature between 200°C and 800°C under an inert gas atmosphere or a reduced pressure.

14. Method as claimed in claim 13, **characterised in that** after the tempering in step f):
g) the gel layer is treated with a hydrophobing agent which replaces OH groups by alkyl groups.

15. Installation for carrying out a method as claimed in one of claims 1 to 14, **characterised in that** steps b) to d) are performed in a first module, which has at least one chamber with a device for producing a saturated atmosphere of the solvent and with a device for adjusting the temperature; and
that the step e) is performed in a second module, which has a gas-tight sealable drying chamber with a device for reducing the pressure in the chamber and a device for conducting the solvent converted into the gaseous state out of the drying chamber.

16. Installation as claimed in claim 15, **characterised in that** the step b) is performed in a spinning chamber and the steps c) to d) are performed in a gel-forming chamber, whereby the gel-forming chamber can accommodate a plurality of substrates.

17. Installation as claimed in claim 15 or 16, **characterised in that** the first and second module are coupled to a transport device for the substrate and that the transport device also couples the second module to a third module for post-treatment, whereby the third module has a chamber with a tempering device for increasing the substrate temperature to a temperature of between 200°C and 800°C and a device for producing a reduced pressure or inert gas atmosphere in the chamber.

## Revendications

1. Procédé de production d'une couche d'aérogel sur un substrat, dans lequel :
a) un précurseur est préparé par mélange d'au moins une substance provenant d'un groupe de substances comprenant des silicates, des alcoolates métalliques, des aluminates et des borates avec un solvant pour la formation d'un lyosol,
b) le mélange précurseur ou le lyosol formé à partir de celui-ci est appliqué sur le substrat,
c) à partir du lyosol est formé un gel, avec choix d'une température à laquelle le solvant est à l'état liquide,
d) ensuite, à une pression comprise entre 0,5 et 2 bar, la température est abaissée d'environ 3 à 70 K, de préférence de 5 à 15 K, au-dessous du point où le solvant passe à l'état solide, et
e) ensuite, dans une chambre de séchage, avec abaissement de la pression, le solvant est mis à l'état gazeux au-dessous du point triple et enlevé de la couche de gel, et le solvant gazeux est évacué de la chambre de séchage.

2. Procédé selon la revendication 1, **caractérisé par le fait qu'**il est utilisé un solvant qui présente un point triple à une température supérieure à 0 °C, de préférence supérieure à 15 °C.

3. Procédé selon la revendication 1, **caractérisé par le fait que** comme solvant est utilisé un alcool tertiaire de basse masse moléculaire, de préférence le t-butanol.

4. Procédé selon l'une des revendications 1 à 3, **caractérisé par le fait que** dans l'étape a), un précurseur est préparé par mélange d'une substance constituée en majeure partie d'un alcoxysilane avec un alcool tertiaire de basse masse moléculaire comme solvant et avec de l'eau.

5. Procédé selon la revendication 4, **caractérisé par le fait que** du tétraéthoxysilane (TEOS) est mélangé avec plus de 2 fois la quantité (molaire) de t-butanol, de préférence avec 4 à 30 fois la quantité de t-butanol, et de l'eau est ajoutée en une quantité qui correspond à 2 à 30 fois, de préférence à 6 à 10 fois, la quantité de tétraéthoxysilane.

6. Procédé selon l'une des revendications 1 à 5, **caractérisé par le fait que** dans l'étape a), le précurseur est préparé par d'abord mélange d'une substance du groupe de substances avec le solvant et ensuite addition de l'eau, le solvant étant, avant le mélange, liquéfié par chauffage.

7. Procédé selon l'une des revendications 1 à 6, **caractérisé par le fait que** dans l'étape a), un catalyseur est ajouté pour accélérer la formation de gel.

8. Procédé selon l'une des revendications 1 à 7, **caractérisé par le fait qu'**avant l'application du lyosol sur le substrat a lieu une prégélification.

9. Procédé selon la revendication 8, **caractérisé par le fait que** le mélange précurseur, dans l'étape a), est stocké pendant une durée comprise entre une heure et plusieurs jours à une température à laquelle le mélange précurseur est sous forme liquide et dans une atmosphère saturée en solvant.

10. Procédé selon l'une des revendications 1 à 9, **caractérisé par le fait qu'**après l'étape c) et avant l'étape d), la couche de gel appliquée sur le substrat est lavée avec le solvant.

11. Procédé selon la revendication 10, **caractérisé par le fait que** lors du lavage est ajouté un agent hydrophobisant qui remplace l'eau et les groupes OH dans la couche de gel par des groupes alkyles.

12. Procédé selon l'une des revendications 1 à 11, **caractérisé par le fait que** les étapes a) à d) sont exécutées à des pressions comprises entre 0,5 et 1 bar.

13. Procédé selon l'une des revendications 1 à 12, **caractérisé par le fait qu'**après l'enlèvement du solvant de la couche de gel dans l'étape e) :
f) la couche d'aérogel appliquée sur le substrat est recuite à une température comprise entre 200 °C et 800 °C et dans une atmosphère de gaz inerte ou sous dépression.

14. Procédé selon la revendication 13, **caractérisé par le fait qu'**après le recuit dans l'étape f) :
g) la couche de gel est traitée avec un agent hydrophobisant qui échange les groupes OH contre des groupes alkyles.

15. Installation pour la mise en oeuvre d'un procédé selon l'une des revendications 1 à 14,
**caractérisée par le fait**
**que** les étapes b) à d) sont exécutées dans un premier module qui présente au moins une chambre ayant un dispositif de production d'une atmosphère de solvant saturée et un dispositif de réglage de la température, et
**que** l'étape e) est exécutée dans un deuxième module qui présente une chambre de séchage pouvant être fermée de manière étanche aux gaz et ayant un dispositif d'abaissement de la pression dans la chambre et un dispositif d'évacuation de la chambre de séchage du solvant passé à l'état gazeux.

16. Installation selon la revendication 15, **caractérisée par le fait que** l'étape b) est exécutée dans une chambre de centrifugation et les étapes c) et d) sont exécutées dans une chambre de formation de gel, la chambre de formation de gel pouvant recevoir plusieurs substrats.

17. Installation selon l'une des revendications 15 et 16, **caractérisée par le fait que** le premier et le deuxième modules sont couplés à un dispositif de transport du substrat et que le dispositif de transport, en outre, couple le deuxième module à un troisième module pour le post-traitement, le troisième module présentant une chambre ayant un dispositif de recuit pour l'élévation de la température du substrat à une valeur comprise entre 200 °C et 800 °C et un dispositif de création dans la chambre d'une atmosphère en dépression ou de gaz inerte.
